Europäisches Patentamt

European Patent Office

Office européen des brevets

(19)

(11) **EP 1 575 161 A1**

(12) **DEMANDE DE BREVET EUROPEEN**

(43) Date de publication:
**14.09.2005 Bulletin 2005/37**

(51) Int Cl.⁷: **H03F 3/19**

(21) Numéro de dépôt: **05392001.3**

(22) Date de dépôt: **07.03.2005**

(84) Etats contractants désignés:
**AT BE BG CH CY CZ DE DK EE ES FI FR GB GR HU IE IS IT LI LT LU MC NL PL PT RO SE SI SK TR**
Etats d'extension désignés:
**AL BA HR LV MK YU**

(30) Priorité: **12.03.2004 FR 0402596**

(71) Demandeur: **STMicroelectronics S.A.**
**92120 Montrouge (FR)**

(72) Inventeurs:
• **Pousset, Fabien**
  **38320 Herbey (FR)**
• **Grasset, Jean-Charles**
  **38430 Moirans (FR)**
• **Cathelin, Philippe**
  **38190 Laval (FR)**

(74) Mandataire: **Schuffenecker, Thierry**
**97, chemin de Cassiopée,**
**Domaine de l'étoile**
**06610 La Gaude (FR)**

(54) **Circuit de conversion d'un signal différentiel en un signal non différentiel, et émetteur RF doté d'un tel circuit**

(57) Un circuit de conversion d'un signal différentiel en un signal non différentiel comportant une première et une seconde entrées recevant respectivement une première et une seconde composantes d'un signal différentiel. Le circuit comporte un unique transistor bipolaire (31) ayant un émetteur, une base et un collecteur. Le transistor est polarisé de manière à laisser s'écouler un courant d'émetteur suffisant pour permettre une conversion linéaire d'un signal différentiel RF, par exemple. Les deux composantes du signal différentiel RF sont respectivement injectées dans l'émetteur et dans la base du transistor bipolaire en sorte que l'on réalise au moyen d'un circuit très simple une conversion remarquablement linéaire.

Le circuit est particulièrement adapté à la réalisation d'une chaîne de transmission RF intégrée.

Fig. 3

**Description**

**Domaine technique de l'invention**

La présente invention concerne le domaine des circuits électronique et notamment un circuit de conversion d'un signal différentiel en un signal non différentiel.

**Etat de la technique**

Dans bien des applications électroniques, et notamment dans les systèmes de communication, le traitement du signal est effectué sous une forme différentielle afin de lui assurer une linéarité optimale et surtout une immunité aux perturbations extérieures.

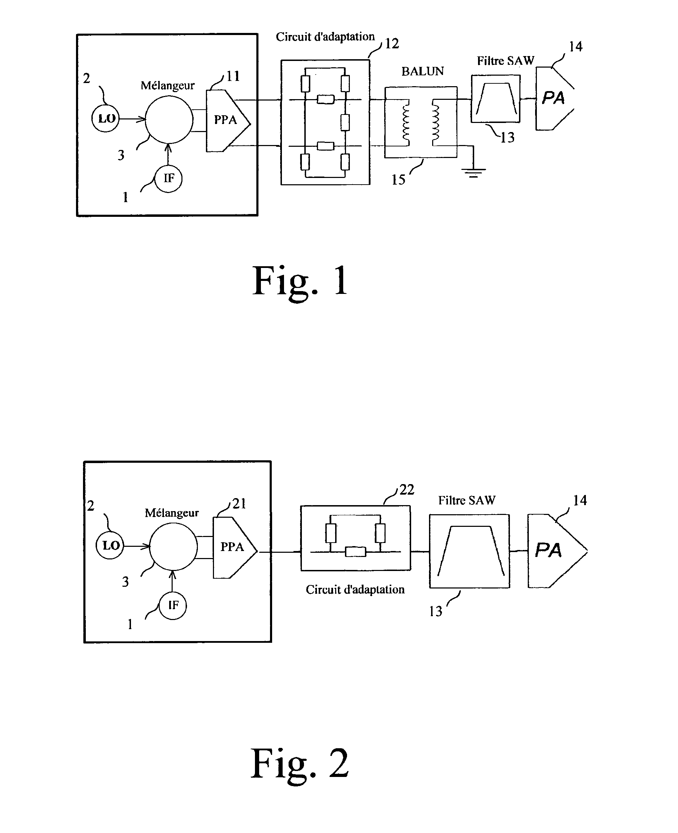

Cela est particulièrement le cas dans le domaine des transmissions. Si l'on considère par exemple une chaîne de transmission RF telle que représentée en figure 1, on voit qu'un signal de fréquence intermédiaire 1 *(Intermediary Frequency IF )* est mélangé à un signal 2 généré par un oscillateur local (LO) au moyen d'un mélangeur 3 afin de produire un signal RF, lequel est ensuite transmis à un préamplificateur PPA 11 *(Pre Power Amplifier* dans la littérature anglo-saxonne). L'immunité du signal aux perturbations extérieures et la linéarité de traitement d'une telle chaîne-illustrée uniquement à titre d'exemple -sont assurées par le mode différentiel utilisé pour les signaux et, en général, on peut réaliser le mélangeur 3 et le pré-amplificateur 11 au moyen d'un même circuit intégré. En sortie de l'amplificateur 11, le signal est transmis à un circuit d'adaptation d'impédance 12, puis à un circuit dit BALUN 15 qui effectue la conversion du signal en un mode non différentiel avant sa transmission à un filtre acoustique SAW 13 (ou *Surface Acoustic Wave* dans la littérature anglo-saxonne), lequel est très sélectif pour ne prendre que la partie RF du signal. Une fois filtré, le signal non différentiel est transmis à un amplificateur de puissance 14 pour y être amplifié avant d'être transmis à l'antenne d'émission (non représentée). Le filtre SAW et le PPA sont généralement non différentiels. C'est pourquoi le BALUN est utilisé pour effectuer la conversion du signal différentiel en un signal non différentiel.

Comme on le voit sur le schéma de la figure 1, le bloc BALUN 15 effectue la conversion du signal différentiel en signal non différentiel. L'inconvénient d'une telle structure réside dans le fait que le BALUN 15 est un élément externe au circuit intégré réalisant le mélangeur et le pré-amplificateur, ce qui accroît d'une manière significative le coût de fabrication de la fonction.

Une deuxième technique existe. Elle consiste à n'utiliser qu'une seule des deux sorties différentielles du préamplificateur et à remplacer le circuit d'adaptation différentiel 12 par un circuit d'adaptation non différentiel 22. Cette technique permet d'éviter l'utilisation du BALUN. Cependant, cette solution est coûteuse d'un point de vue consommation électrique et n'est pas optimale d'un point de vue linéarité du signal.

Une troisième technique connue permettant de supprimer le BALUN consiste à utiliser un circuit de type CAPRIO QUAD (évolution du Cross-Quad proposée par Caprio). Cette technique permet d'effectuer la conversion d'un signal différentiel en un signal non différentiel, au dépens de la consommation et de la linéarité.

Une quatrième technique connue sous l'appellation *current combiner* dans la littérature anglo-saxonne permet d'effectuer la conversion d'un signal différentiel en un signal non différentiel. Ce circuit comporte un circuit accordé basé sur un réseau passif d'inductances et de capacités. L'inconvénient de cette solution réside entres autres, dans le fait que les inductances - lorsqu'elles sont intégrées dans le circuit intégré - occupent une surface non négligeable sur le substrat de silicium et, de ce fait, accroissent le coût de fabrication d'un tel circuit. De plus, les performances de ce type de circuit dépendent beaucoup de la précision avec laquelle on arrive à fabriquer ses éléments.

On constate donc que l'on ne connaît pas encore de solution simple permettant d'intégrer sur un substrat de semi-conducteur un circuit de conversion d'un signal différentiel en un signal non différentiel, particulièrement adapté à la réalisation d'une chaîne de transmission d'un signal RF. C'est la raison pour laquelle, on retrouve, en pratique, dans bon nombre de réalisations concrètes, un BALUN extérieur au circuit intégré dont l'usage se fait ressentir sur le coût de fabrication du transmetteur.

Il serait souhaitable de pouvoir disposer d'un circuit occupant un minimum de place sur un substrat et qui permette de réaliser la conversion d'un signal différentiel en un signal non différentiel.

**Exposé de l'invention**

La présente invention a pour but de proposer un circuit de conversion d'un signal différentiel en un signal non différentiel, simple et bon marché , et qui offre une grande linéarité.

C'est un autre but de la présente invention que de réaliser un convertisseur de signal différentiel particulièrement adapté à une chaîne d'émission d'un système de transmission RF.

L'invention réalise ces buts au moyen d'un circuit de conversion d'un signal différentiel en un signal non différentiel qui comporte une première et une seconde entrées recevant respectivement une première et une seconde composantes d'un signal différentiel. Le circuit comporte un unique transistor bipolaire (31) ayant un émetteur, une base et un collecteur. Le transistor est polarisé de manière à laisser s'écouler un courant d'émetteur suffisant pour permettre une conversion linéaire d'un signal différentiel RF, par exemple. Les deux composantes du signal différentiel RF sont respectivement injectées dans l'émetteur et dans la base du transistor bipolaire en sorte que l'on réalise au moyen d'un circuit très simple une conversion remarquablement linéaire.

On réalise ainsi de manière particulièrement simple et efficace un circuit de conversion différentiel - non différentiel qui ne requiert aucune inductance et qui est facile à intégrer sur un substrat de semi-conducteur.

Préférentiellement, la base et l'émetteur sont connectés à la masse par des resistances Zb et Ze de valeur plus faible que l'impédance interne de la source différentielle attaquant le circuit de conversion.

Dans un mode de réalisation particulier, on injecte une contre-réaction du courant de sortie du collecteur au moyen d'une connexion entre le collecteur et la base par la mise en série d'une impédance Zb et d'un gain Kb. De la même manière, on injecte une contre-réaction du courant de sortie au moyen d'une connexion entre le collecteur et l'émetteur par la mise en série d'une impédance Ze et d'un gain -Ke.

L'invention permet la réalisation d'une chaîne de transmission RF intégrée comportant :

- un mélangeur destiné à mélanger un signal de fréquence intermédiaire et un signal généré par un oscillateur local afin de produire un signal RF ;
- un circuit préamplificateur différentiel destiné à amplifier le signal de sortie dudit mélangeur et générant en sortie une première et une seconde composantes d'un signal différentiel ;
- un convertisseur différentiel-non différentiel comportant un unique transistor bipolaire comportant un émetteur, une base et un collecteur, ledit transistor étant polarisé de manière à laisser s'écouler un courant d'émetteur suffisant pour permettre une conversion linéaire ; l'émetteur dudit transistor bipolaire recevant la première composante dudit signal différentiel, et la base dudit transistor recevant la seconde composante du signal différentiel, le collecteur dudit transistor générant en sortie un courant proportionnel à la différence de ladite première et seconde composantes du signal différentiel.

## Description des dessins

D'autres caractéristiques, buts et avantages de l'invention apparaîtront à la lecture de la description et des dessins ci-après, donnés uniquement à titre d'exemples non limitatifs. Sur les dessins annexés :

La figure 1 illustre une chaîne classique d'émission d'un signal RF, avec une sortie de circuit intégré différentielle et l'utilisation d'un BALUN.

La figure 2 illustre une seconde technique connue permettant de s'éviter l'usage du BALUN, basée sur un préamplificateur non différentiel.

La figure 3 illustre un mode de réalisation préféré d'un circuit de conversion d'un signal différentiel en un signal non différentiel conforme à la présente invention.

La figure 4 illustre un second mode de réalisation d'un circuit de conversion d'un signal différentiel en un signal non différentiel.

La figure 5 illustre l'usage du circuit convertisseur selon la présente invention dans une chaîne de transmission RF.

## Description d'un mode de réalisation préféré

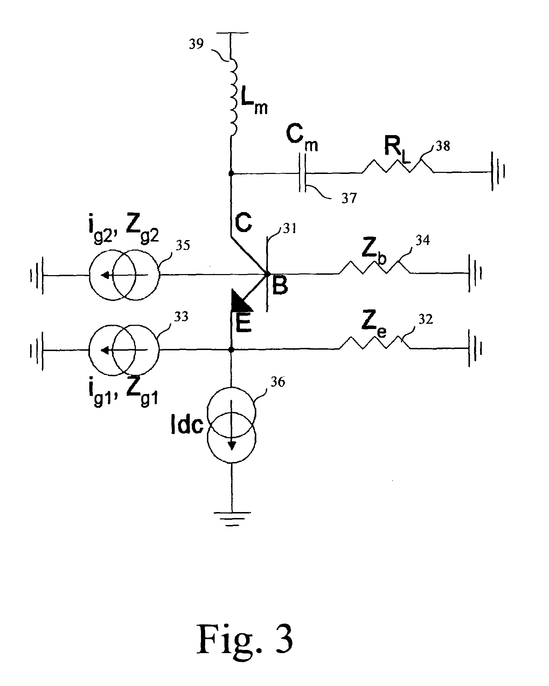

La figure 3 illustre un mode de réalisation d'un circuit de conversion d'un signal différentiel en un signal non différentiel, conforme à la présente invention.

Ce circuit est basé sur un transistor bipolaire 31 comportant une base, un émetteur et un collecteur et qui est polarisé au moyen d'un courant de repos ou statique - représenté par une source de courant 36 ( $I_{dc}$ ) - suffisamment élevé pour assurer la linéarité de la conversion. En pratique, on choisira le courant de repos plus élevé que le courant RF.

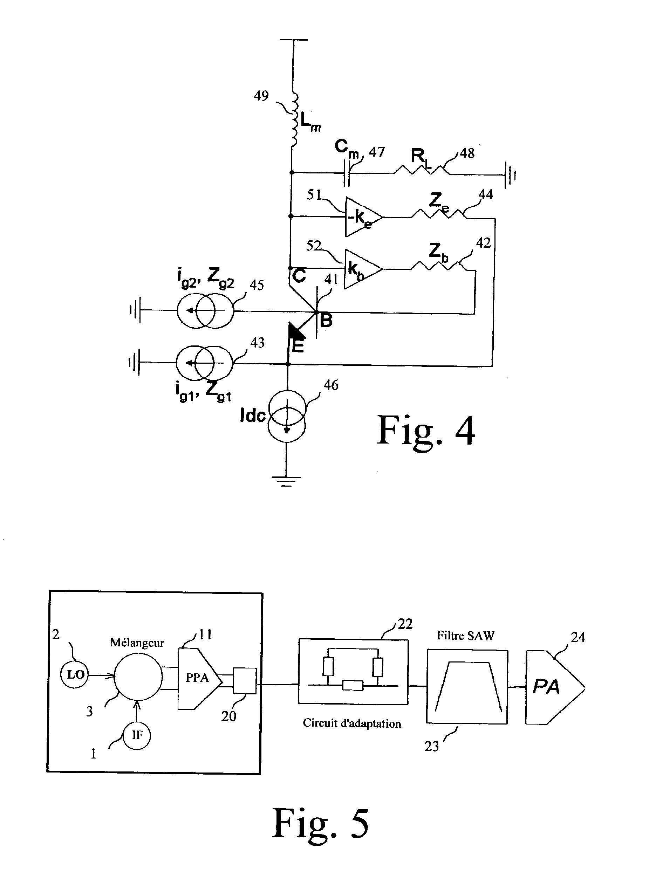

Le circuit est attaqué par deux signaux différentiels que l'on a représenté, dans un souci de clarté, par deux sources de courants, respectivement une première source 33 (ig1) présentant une impédance interne Zg1, et une seconde source 35 (ig2) d'impédance Zg2. D'une manière pratique, les impédances Zg1 et Zg2 correspondent aux impédances de sortie de l'étage précédent le circuit convertisseur, en général un circuit préamplificateur tel qu'on le verra dans la figure 5.

L'émetteur du transistor 31 est connecté à la première source de courant 33 et est également connecté à la masse via une première impédance 32 (Ze), laquelle pourra être une résistance pure.

La base du transistor 31 est connectée à la seconde source de courant 35 et est également connectée à la masse via une seconde impédance ou résistance 34 (Zb).

D'une manière pratique, on choisira les impédances Zb et Ze suffisamment faibles par rapport aux impédances internes Zg1 et Zg2 des deux entrées différentielles. On notera que Ze et Zb ne sont pas forcément des résistances pures. Ce sont plus généralement des impédances (avec une partie réelle et une partie imaginaire).

En sortie, le transistor 31 est chargé par un réseau d'adaptation qui pourra être quelconque. Dans le circuit représenté dans la figure 3, on a illustré le réseau d'adaptation par la mise en parallèle d'une inductance 39 (Lm) et d'un groupement comportant - en série - une capacité 37 (Cm) et une charge 38 (RL).

Ce réseau qui est illustré dans la figure 3 ne constitue qu'un exemple particulier de réseau d'adaptation d'impédance et un homme du métier pourra concevoir tout autre réseau particulier.

Si gm est le coefficient de transconductance du transistor 31, si $\beta$ est le rapport des courants de collecteur et de base, on peut écrire en première approximation la formule suivante pour le courant RF de sortie de collecteur i en fonction des deux composantes RF différentielles i1 et i2 :

$$i = \frac{g_m \cdot (Z_2 \cdot i_2 - Z_1 \cdot i_1)}{1 + g_m \cdot Z_1 \cdot \dfrac{\alpha_z}{\alpha}}$$

$$Z_1 = \frac{Z_{g1} \cdot Z_e}{Z_{g1} + Z_e} \qquad Z_2 = \frac{Z_{g2} \cdot Z_b}{Z_{g2} + Z_b} \qquad \alpha_z = \frac{1}{\beta + 1} \cdot \frac{Z_2}{Z_1} + 1 \qquad \alpha = \frac{\beta}{\beta + 1}$$

On constate donc que le transistor 31 réalise d'une manière simultanée une fonction d'amplification et une fonction de conversion d'un signal différentiel comportant deux composantes i1 et i2 respectivement injectées sur l'émetteur et la base du transistor, et converties au niveau du collecteur en un signal non différentiel.

On a surtout constaté une linéarité remarquable dans la conversion assurée par ce circuit d'une grande simplicité et d'une non moins grande efficacité.

Cette performance est d'autant plus étonnante que l'approche qui est décrite, basée sur un traitement a priori non symétrique des deux composantes du signal différentiel, tranche nettement avec une approche classique.

En effet, on rappelle que classiquement, on prévoit pour chacune des deux composantes d'un signal différentiel un circuit parfaitement symétrique, tel que, par exemple, la base d'un amplificateur à transconductance.

Avec l'invention, au contraire, on opte d'emblée pour une approche non symétrique : la première composante (i1 ou ig1) du signal différentiel est présentée à la base du transistor 31 tandis que la seconde composante (i2 ou ig2) est présentée sur l'électrode d'émetteur de ce même transistor.

On réalise ainsi un traitement des plus particuliers d'un signal différentiel au moyen d'un unique transistor, ce qui tranche drastiquement de l'approche classique qui consiste à traiter un signal différentiel au moyen d'une structure symétrique, telle que, par exemple, les deux bases formant l'entrée d'un amplificateur différentiel à transconductance. De ce fait, la structure asymétrique formée de l'unique transistor bipolaire 31 est utilisée conformément à la présente invention pour traiter les deux composantes d'un signal différentiel présentant, le cas échéant, un mode commun par rapport à la masse auquel est connecté ce même transistor.

Il est inutile d'insister sur la facilité d'intégration d'un tel circuit sur un substrat de semi-conducteur.

La figure 4 montre une variante d'exécution dans laquelle, les deux impédances Zb et Ze ne sont pas mises à la masse mais sont utilisées pour réintroduire une contre réaction, respectivement vers la base et vers l'émetteur. D'une manière plus précise, et dans un souci de clarté, chaque élément 4x de la figure 4 correspond à un élément de 3x de la figure 3. Le circuit de la figure 4 comporte un transistor bipolaire 41 comportant une base, un émetteur et un collecteur. Le transistor 41 est polarisé, comme précédemment, au moyen d'une source de courant Idc 46 qui permet l'écoulement d'un courant d'émetteur de repos suffisamment élevé par rapport au courant RF. Les deux entrées du signal différentiel, respectivement représentées par deux sources de courants 43 (ig1, d'impédance Zg1) et 45 (ig2, d'impédance Zg2) , sont connectées à l'émetteur et à la base du transistor 41, dont le collecteur est chargé par un réseau d'adaptation comportant une inductance Lm 49, une capacité Cm 47 et une charge RL 48.

Le collecteur du transistor 41 est connecté à l'entrée d'un premier amplificateur 51 de gain - Ke, dont la sortie est connectée via une impédance Ze 44 à l'émetteur du transistor 41. En pratique, le gain - Ke pourra être réalisé au moyen d'un élément actif supplémentaire au transistor 31, tel que, par exemple, un autre transistor bipolaire.

De la même manière, le collecteur du transistor 41 est connecté à l'entrée d'un second amplificateur 51 de gain Kb , dont la sortie est connectée via une impédance Zb 42 à la base du transistor 41. Comme pour le gain - Ke, on pourra réaliser le kb au moyen d'un élément actif supplémentaire.

On pourra également prévoir des variantes d' exécution. Notamment et à titre d'exemple, la polarisation du transistor 4 pourra se faire à l'aide d'un simple miroir de courant. On s'arrange dans tous les cas pour que l'impédance introduite pour réaliser la polarisation en continue n'interfère pas en régime RF.

Dans cette variante, on réduit le gain de l'amplification par l'introduction de la contre-réaction dans la base et dans l'émetteur, mais on accroît encore plus la linéarité de la conversion. La contre-réaction permet, de plus, de contrôler l'adaptation d'impédance de sortie.

La figure 5 illustre l'utilisation d'un circuit de conversion tel que décrit précédemment dans une chaîne de transmission d'un signal RF. Comme on le voit, le signal FI 1 est mélangé au signal 2 généré par un oscillateur local au moyen d'un mélangeur 3 et est ensuite amplifié via un pré-amplificateur différentiel PPA 11. En sortie du préamplificateur, le signal différentiel est alors présenté à l'entrée d'un convertisseur 20 conforme à celui décrit en relation avec la figure 3, lequel génère alors un signal non différentiel.

Le circuit qui vient d'être décrit est susceptible d'être utilisé dans bien d'autres applications que la RF.

**Revendications**

1. Circuit de conversion d'un signal différentiel en un signal non différentiel, ledit circuit comportant une première et une seconde entrées recevant respectivement une première et une seconde composantes d'un signal différentiel ; le circuit étant **caractérisé en ce qu'**il comporte :

   - un unique transistor bipolaire comportant un émetteur, une base et un collecteur, ledit transistor étant polarisé de manière à laisser s'écouler un courant d'émetteur suffisant pour permettre une conversion linéaire ; ladite première entrée étant connectée à l'émetteur dudit transistor bipolaire, ladite seconde entrée étant connectée à la base dudit transistor bipolaire,
   - et **en ce que** le collecteur dudit transistor génère en sortie un courant proportionnel à la différence de ladite première et seconde composantes du signal différentiel.

2. Circuit selon la revendication 1 **caractérisé en ce que** la base est connectée à la masse via une impédance Zb de valeur plus faible que l'impédance interne de la composante de la source différentielle attaquant le circuit sur la base.

3. Circuit selon la revendication 1 **caractérisé en ce que** l'émetteur est connectée à la masse via une impédance Ze de valeur plus faible que l'impédance interne de la composante de la source différentielle attaquant le circuit sur l'émetteur.

4. Circuit selon la revendication 1 **caractérisé en ce qu'**il comporte une contre-réaction du signal de sortie réalisée au moyen d'une connexion entre le collecteur et la base par la mise en série d'une impédance Zb et d'un gain Kb.

5. Circuit selon la revendication 1 **caractérisé en ce qu'**il comporte une contre-réaction du signal de sortie réalisée au moyen d'une connexion entre le collecteur et l'émetteur par la mise en série d'une impédance Ze et d'un gain -Ke.

6. Circuit de transmission d'un signal RF dans un système de communication, ledit circuit comportant :

   - un mélangeur (3) destiné à mélanger un signal de fréquence intermédiaire et un signal généré par un oscillateur local afin de produire un signal RF ;
   - un circuit préamplificateur (11) différentiel destiné à amplifier le signal de sortie dudit mélangeur et générant en sortie une première et une seconde composantes d'un signal différentiel ;
   - un convertisseur différentiel-non différentiel comportant un unique transistor bipolaire comportant un émetteur, une base et un collecteur, ledit transistor étant polarisé de manière à laisser s'écouler un courant d'émetteur suffisant pour permettre une conversion linéaire ; l'émetteur dudit transistor bipolaire recevant la première composante dudit signal différentiel, et la base dudit transistor recevant la seconde composante du signal différentiel, le collecteur dudit transistor générant en sortie un courant proportionnel à la différence de ladite première et seconde composantes du signal différentiel.

7. Circuit de transmission selon la revendication 6 **caractérisé en ce que** la base est connectée à la masse via une impédance Zb de valeur plus faible que l'impédance interne de sortie dudit préamplificateur différentiel .

8. Circuit selon la revendication 6 **caractérisé en ce que** l'émetteur est connectée à la masse via une impédance Ze de valeur plus faible que l'impédance interne dudit préamplificateur différentiel.

9. Circuit selon la revendication 6 **caractérisé en ce qu'**il comporte une contre-réaction du signal de sortie réalisée au moyen d'une connexion entre le collecteur et la base par la mise en série d'une impédance Zb et d'un gain Kb.

10. Circuit selon la revendication 6 **caractérisé en ce qu'**il comporte une contre-réaction du signal de sortie réalisée au moyen d'une connexion entre le collecteur et l'émetteur par la mise en série d'une impédance Ze et d'un gain -Ke.

Fig. 1

Fig. 2

Fig. 3

EP 1 575 161 A1

Fig. 4

Fig. 5

9

**Office européen des brevets**

**RAPPORT DE RECHERCHE EUROPEENNE**

Numéro de la demande

EP 05 39 2001

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | EP 0 877 479 A (LUCENT TECHNOLOGIES INC) 11 novembre 1998 (1998-11-11) * page 4, ligne 22 - page 5, ligne 24; figure 2 * | 1-3,6-8 | H03F3/19 |
| Y | | 4,5,9,10 | |
| Y | EP 0 785 617 A (TRW INC) 23 juillet 1997 (1997-07-23) * colonne 5, ligne 40 - colonne 6, ligne 32; figure 1 * | 4,9 | |
| Y | HOROWITZ P; HILL W: "The art of electronics" 1989, CAMBRIDGE UNIVERSITY PRESS , XP002304706 * page 238; figure 4.73 * | 5,10 | |
| X | CH 346 914 A (AUTOPHON AG) 15 juin 1960 (1960-06-15) * page 2, ligne 38 - ligne 82; figure 1 * | 1-3,6-8 | |
| X | US 6 057 737 A (PRITCHARD ERIC K) 2 mai 2000 (2000-05-02) * colonne 2; figure 2 * | 1-3,6-8 | DOMAINES TECHNIQUES RECHERCHES (Int.Cl.7) H03F |
| A | EP 0 595 561 A (PLESSEY SEMICONDUCTORS LTD) 4 mai 1994 (1994-05-04) * figure 1 * | 1-10 | |

Le présent rapport a été établi pour toutes les revendications

| Lieu de la recherche | Date d'achèvement de la recherche | Examinateur |
|---|---|---|
| Munich | 10 mai 2005 | Lorenzo, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 39 2001

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-05-2005

| Document brevet cité au rapport de recherche | | Date de publication | Membre(s) de la famille de brevet(s) | | Date de publication |
|---|---|---|---|---|---|
| EP 0877479 | A | 11-11-1998 | US | 5929708 A | 27-07-1999 |
| | | | CA | 2235019 A1 | 09-11-1998 |
| | | | DE | 69826919 D1 | 18-11-2004 |
| | | | EP | 0877479 A1 | 11-11-1998 |
| | | | JP | 3366571 B2 | 14-01-2003 |
| | | | JP | 11008519 A | 12-01-1999 |
| EP 0785617 | A | 23-07-1997 | US | 5710523 A | 20-01-1998 |
| | | | EP | 0785617 A2 | 23-07-1997 |
| | | | JP | 9205328 A | 05-08-1997 |
| CH 346914 | A | 15-06-1960 | AUCUN | | |
| US 6057737 | A | 02-05-2000 | AU | 6509099 A | 01-05-2000 |
| | | | WO | 0022726 A1 | 20-04-2000 |
| EP 0595561 | A | 04-05-1994 | GB | 2272121 A | 04-05-1994 |
| | | | BR | 9304342 A | 26-07-1994 |
| | | | DE | 69322737 D1 | 04-02-1999 |
| | | | DE | 69322737 T2 | 20-05-1999 |
| | | | EP | 0595561 A1 | 04-05-1994 |
| | | | JP | 7015245 A | 17-01-1995 |
| | | | US | 5378997 A | 03-01-1995 |

EPO FORM P0460

Pour tout renseignement concernant cette annexe : voir Journal Officiel de l'Office européen des brevets, No.12/82